# EUROPEAN PATENT APPLICATION

(11) **EP 1 569 266 A2**
(43) Date of publication of application: **31.08.2005**
(21) Application number: 04020632.8
(22) Date of filing: 31.08.2004
(51) Int. Cl.: H01L 21/285

(54) **Method for fabricating a silicide film, multilayered intermediate structure and multilayered structure**

(30) Priority: 26.02.2004 JP 2004051790
(71) Applicant: National University Corporation Nagoya University, Nagoya-city, Aichi Pref. (JP)
(72) Inventor: Nakatsuka, Osamu, Nagoya City Aichi Pref. (JP); Sakai, Akira, Nagoya City Aichi Pref. (JP); Zaima, Shigeaki, c/o Dept. of Cryst. Mat. Science, Nagoya City, Aichi Pref., 464-8603 (JP); Yasuda, Yukio, Aichi Gun Aichi Pref. (JP); Okubo, Kazuya, Nagoya City Aichi Pref. (JP); Tsuchiya, Yoshinori, Yokohama City Kanagawa Pref. (JP)
(74) Representative: von Hellfeld, Axel

(57) **Abstract**

A silicon substrate (11) is prepared, and a titanium intermediate layer (12) is formed on the silicon substrate. Then, a compound element-containing layer (13) containing compound elements to compose an intended silicide film (23) is formed on the titanium intermediate layer (12), to form a multilayered intermediate structure, which is thermally treated to form the intended silicide film made of silicon elements of the silicon substrate and the compound elements of the compound element-containing layer.

## Description

### BACKGROUND OF THE INVENTION

### Field of the Invention

This invention relates to a method for fabricating a silicide film, and a multilayered intermediate structure for fabricating the same silicide film, and a multilayered structure containing the same silicide film.

### Related art

Conventionally, in the fabrication of a metal/semiconductor junction in a semiconductor integrated circuit, a metal film is deposited on a semiconductor substrate to form a multilayered structure, which is thermally treated to form a metal-semiconductor compound film as the metal/semiconductor junction electrode. In a silicon-based element, in order to fabricate the metal/semiconductor junction, titanium (Ti), cobalt (Co) or nickel (Ni) is employed as a metallic material to form a metallic silicon compound (silicide) film such as a titanium disilicide (TiSi₂) film, a cobalt disilicide (CoSi₂) film, a nickel monosilicide (NiSi) film or a nickel disilicide (NiSi₂) film.

Since the silicide film such as the CoSi₂ film and the NiSi₂ film can match in lattice constant to the silicon substrate by several %, the silicide film can be epitaxially grown on the silicon substrate to be a single crystalline film. Particularly, since the NiSi₂ film can match in lattice constant to the silicon substrate by 0.4%, the NiSi₂ film can be easily epitaxially grown on the silicon substrate by means of thermal treatment at 800°C or over. Therefore, the NiSi₂ is an ideal electrode material in the silicon-based element.

In the fabrication of the NiSi₂ epitaxial film at a higher temperature as mentioned above, however, the deposited nickel silicide film prior to the thermal treatment contains relatively much polycrystalline NiSi. Since the polycrystalline NiSi is thermally unstable, the polycrystalline NiSi agglomerates to form polycrystalline NiSi particles through the thermal treatment. As a result, the structure and the composition uniformity of the intended NiSi₂ epitaxial film may be deteriorated.

Moreover, much inclined facets may be formed to form concave-convex boundary surface between the NiSi₂ epitaxial film and the silicon substrate, originated from the energetic stability at the boundary surface therebetween. As a result, although the NiSi₂) is an ideal electrode material for the silicon-based element, the inherent performance of the NiSi₂ can not be exhibited due to the above-mentioned problems, so that currently, the NiSi₂ can not be employed as the electrode material for the silicon-based element.

### SUMMERY OF THE INVENTION

It is an object of the present invention to form a silicide film which has uniform structure and composition and whereby the boundary surface against a silicon substrate can be flattened for the use of a practical electrode material of a silicon-based element.

In order to achieve the above object, this invention relates to a method for fabricating a silicide film, comprising the steps of:
preparing a silicon substrate,
forming a titanium intermediate layer on the silicon substrate,
forming, on the titanium intermediate layer, a compound element-containing layer containing compound elements to compose an intended silicide film, to form a multilayered intermediate structure, and
thermally treating the multilayered intermediate structure to form the intended silicide film made of silicon elements of the silicon substrate and the compound elements of the compound element-containing layer.

The inventors had been intensely studied to achieve the above object, and as a result, found out the following fact of matters. First of all, a silicon substrate is prepared, and a compound element-containing layer containing compound elements to compose an intended silicide film to be formed later is formed on the silicon substrate to form a multilayered intermediate structure. Then, in the multilayered intermediate structure, a titanium layer is formed between the silicon substrate and the compound element-containing layer. In this case, the boundary reaction between the silicon substrate and the compound element-containing layer can be prevented through thermal treatment by the titanium intermediate layer.

Therefore, if the multilayered intermediate structure containing the silicon substrate, the titanium intermediate layer and the compound element-containing layer is thermally treated to form a silicide film made of silicon elements of the silicon substrate and compound elements of the compound element-containing layer, the boundary surface between the silicon substrate and the silicide film can be formed flat in the order of atomic level.

In addition, according to the fabricating method of the present invention, the intended silicide film can be formed at extremely low temperature, e.g., around 350°C. Therefore, the degradation of a silicide film with agglomeration is prevented due to the direct formation of the intended silicide film at low temperature without the prior formation of a thermally unstable polycrystalline NiSi film..

Moreover, even though the intended silicide film, particularly a NiSi₂ film is maintained at a higher temperature, e.g., of 600°C or over after the formation, agglomerated particles can not be created. Therefore, the intended silicide film can exhibit uniform structure and composition at the higher temperature. As a result, the intended silicide film, particularly, the NiSi₂ film can be preferably employed as a practical electrode material of a silicon-based element also due to the high crystallinity of the epitaxial growth.

Conventionally, in the formation of the NiSi₂ film, the thermal treatment is carried out at 800°C or over. In contrast, in the present invention, the thermal treatment is carried out only at 350°C or below. Therefore, the NiSi₂ film can be easily formed.

In a preferred embodiment, the thickness of the titanium intermediate layer is set to 50nm or below. In this case, the above-mentioned function/effect of the titanium intermediate layer can be enhanced. Also, the remnant amount of titanium in the intended silicide film can be decreased, so that the performance deterioration of the intended silicide film due to the remnant titanium can be prevented.

In another preferred embodiment, an additional thermal treatment can be carried out for the silicide film. In this case, the boundary surface between the silicon substrate and the silicide film can be flattened more precisely. The additional thermal treatment can be carried out, e.g., at 400°C or over.

The fabricating method of the present invention can be applied for the fabrication of a silicide film such as a TiSi₂ film, a CoSi₂ film, or a NiSi₂ film, but preferably for the fabrication of the NiSi₂ film.

As mentioned above, according to the present invention can be provided a silicide film which has uniform structure and composition and whereby the boundary surface against a silicon substrate can be flattened for the use of a practical electrode material of a silicon-based element.

### BRIEF DESCRIPTION OF THE DRAWINGS

For better understanding of the present invention, reference is made to the attached drawings, wherein
Fig. 1 illustrates a fabricating step in the fabricating method of the present invention,
Fig. 2 also illustrates a fabricating step in the fabricating method of the present invention,
Fig. 3 is a graph illustrating an X-ray diffraction patterns of a nickel silicide film according to the fabricating method of the present invention,
Fig. 4 is a graph illustrating an X-ray diffraction patterns of a nickel silicide film according to a different fabricating method from the present invention,
Fig. 5 is a surface SEM photograph of the nickel silicide film according to the fabricating method of the present invention,
Fig. 6 is a surface SEM photograph of the nickel silicide film according to the different fabricating method from the present invention,
Fig. 7 is a cross sectional TEM photograph of the nickel silicide film according to the fabricating method of the present invention, and
Fig. 8 is a cross sectional TEM photograph of the nickel silicide film according to the different fabricating method from the present invention.

### DESCRIPTION OF THE PREFERRED EMBODIMENTS

This invention will be described in detail with reference to the accompanying drawings.

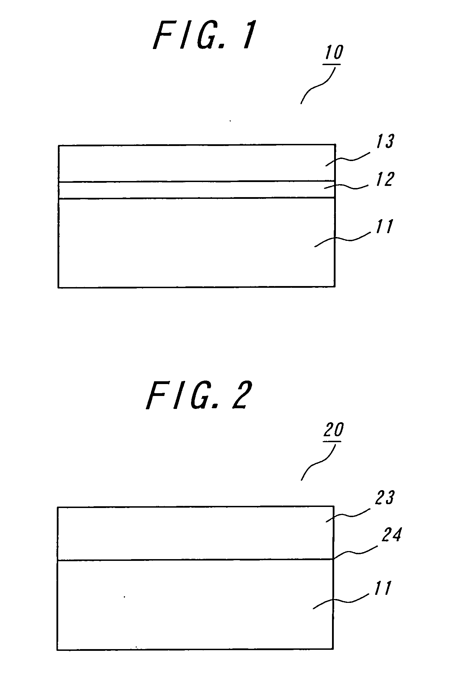

Figs. 1 and 2 illustrate respective fabricating steps in the fabricating method of the present invention. First of all, as illustrated in Fig. 1, a silicon substrate 11 is prepared, and a titanium intermediate layer 12 is formed on the silicon substrate 11. Then, a compound element-containing layer containing compound elements to compose an intended silicide film to be formed later is formed on the titanium intermediate layer 12 to form a multilayered intermediate structure 10.

Then, a thermal treatment is carried out for the multilayered intermediate structure under vacuum atmosphere, nitrogen atmosphere or argon atmosphere to interdiffuse silicon elements of the silicon substrate 11 and the compound elements of the compound element-containing layer one another and thus, to form an intended silicide film 23 on the silicon substrate 11, as illustrated in Fig. 2.

The titanium intermediate layer 12 is formed in order to prevent the boundary reaction between the silicon substrate 11 and the silicide film 23 through the thermal treatment for the fabrication of the silicide film 23. Therefore, no facet is created at the boundary surface 24 between the silicon substrate 11 and the silicide film 23, so that the boundary surface 24 can be flattened more precisely, e.g., in the order of atomic level. As a result, no concave-convex boundary surface is formed.

Then, the thermal treatment is carried out at relatively low temperature, e.g., of 350°C or below. Therefore, the intended silicide film 23 can be formed at the relatively low temperature. Therefore, the degradation of a silicide film with agglomeration is prevented due to the direct formation of the intended silicide film at low temperature without the prior formation of a thermally unstable polycrystalline NiSi film.

Moreover, even though the intended silicide film, particularly a NiSi₂ film is maintained at a higher temperature, e.g., of 600°C or over after the formation, agglomerated particles can not be created. Therefore, the intended silicide film can exhibit uniform structure and composition at the higher temperature. As a result, the intended silicide film, particularly, the NiSi₂ film can be preferably employed as a practical electrode material of a silicon-based element also due to the high crystallinity of the epitaxial growth.

It is desired to set the thickness of the titanium intermediate layer to 50nm or below, preferably 20nm or below, more preferably 5nm or below. In this case, the above-mentioned function/effect of the titanium intermediate layer can be more enhanced.

Not restricted, the lower limit of the thickness of the titanium intermediate layer 12 is preferably set to 0.5nm in view of the same function/effect of the titanium intermediate layer.

The titanium intermediate layer 12 is dispersed into the silicide film 23 through the thermal treatment, so that the silicide film 23 contains a small amount of Ti, in addition to the silicon elements and the compound elements.

The thickness of the compound element-containing layer 13 may be appropriately controlled on the thickness of the intended silicide film 23. All of the compound element-containing layer 13 may be converted into the silicide film 23, but only a part of the compound element-containing layer 23 may be converted into the silicide film 23. If the thickness of the titanium intermediate layer 12 is set to 50nm or below, the thickness of the compound element-containing layer 13 may be set within 10-100nm. In this embodiment, as illustrated in Fig. 2, all of the compound element-containing layer 13 is converted into the silicide film 23.

If the compound element-containing layer 13 is made of a Co layer, a Ni layer or a Pt layer to form a silicide film such as a corresponding CoSi₂ film, NiSi₂ film or PtSi film, the silicide film can be formed as an epitaxial film by controlling the thermal treatment condition such as thermal treatment temperature. Therefore, the silicide film such as the CoSi₂ film, the NiSi film or the PtSi film can be used as a practical electrode material of a silicon based element.

In the present invention, an additional thermal treatment can be carried out for the silicide film 23 after the formation as mentioned above. In this case, the boundary surface between the silicon substrate 11 and the silicide film 23 can be easily and effectively flattened more precisely. Concretely, the boundary surface 24 can be formed flat in the order of atomic level under high reproducibility.

In the additional thermal treatment for the NiSi₂ film, for example, the multilayered structure 20 made of the silicon substrate 11 and the NiSi₂ film 23 is heated at 400°C or over, particularly 600°C or over under a vacuum, nitrogen or argon atmosphere. The upper limit temperature of the additional thermal treatment may be set to 1000°C. If the additional thermal treatment is carried out beyond 1000°C, the boundary surface can not be more flattened. On the contrary, the boundary surface may be roughed, and the flatness of the boundary surface may be deteriorated.

### (Examples)

### <Formation of Silicide Film>

### (Example 1)

A (100) Si substrate was prepared, and a titanium intermediate layer was formed in a thickness of 2nm on the Si substrate. Then, a nickel layer was formed in a thickness of 9nm on the titanium intermediate layer to form a multilayered intermediate structure. The multilayered intermediate structure was disposed in a vacuum condition, and thermally treated at 350°C for 30 minutes to form a nickel silicide film on the Si substrate.

### (Example 2)

The multilayered intermediate structure was formed in the same manner as in Example 1. Then, the multilayered intermediate structure was disposed in a nitrogen atmosphere, and in addition, thermally treated within 550-850°C.

### (Comparative Example 1)

Except that the titanium intermediate layer was not formed, a nickel silicide film was formed in the same manner as in Example 1.

### (Comparative Example 2)

The multilayered intermediate structure with no titanium intermediate layer was formed in the same manner as in Comparative Example 1, and in addition, thermally treated under the same condition as in Example 1.

### <Evaluation of Silicide Film>

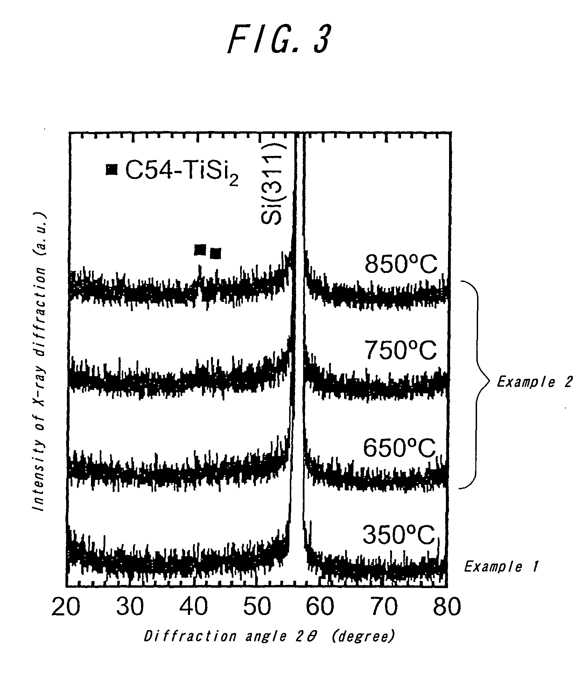

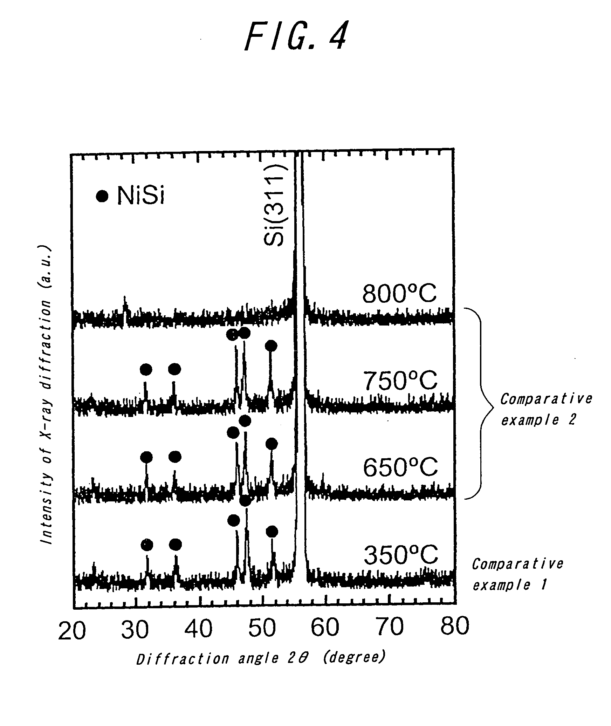

Fig. 3 are graphs illustrating the X-ray diffraction patterns of the nickel silicide films formed in Examples 1 and 2. Fig. 4 are graphs illustrating the X-ray diffraction patterns of the nickel silicide films formed in Comparative Examples 1 and 2. In Figs. 3 and 4, the temperature of 350°C means a thermal treatment temperature at the formation of the nickel silicide film, and the temperatures of 650°C, 750°C and 850°C mean additional thermal treatment temperatures, respectively.

As is apparent from Fig. 3, the nickel silicide films formed through the 350°C thermal treatment, the 650°C and 750°C additional thermal treatments exhibit no peak except peaks originated from Si(311) crystal. On the other hand, the nickel silicide film formed through the 850°C additional thermal treatment exhibits only peaks originated from C54-TiSi₂ crystal. In an epitaxial NiSi₂ film, since the X-ray diffraction peak of the NiSi₂ crystal phase matches to the X-ray diffraction peak of the Si(311) crystal plane, it is turned out that the nickel silicide films obtained through the thermal treatment of 350°C and the additional thermal treatments of 650-850°C in Examples are epitaxial NiSi₂ films, respectively.

As is apparent from Fig. 4, in Comparative Example 1, a NiSi polycrystal is created through the 350°C thermal treatment. Then, the NiSi crystal phase exists after the additional thermal treatment within 650-750°C, but disappears after the additional thermal treatment at 850°C. In view of the matching of the X-ray diffraction peak of the NiSi₂ crystal phase to the one of the Si(311) crystal plane, it is turned out that at the additional thermal treatment at 850°C, a NiSi₂ phase is created in the nickel silicide film.

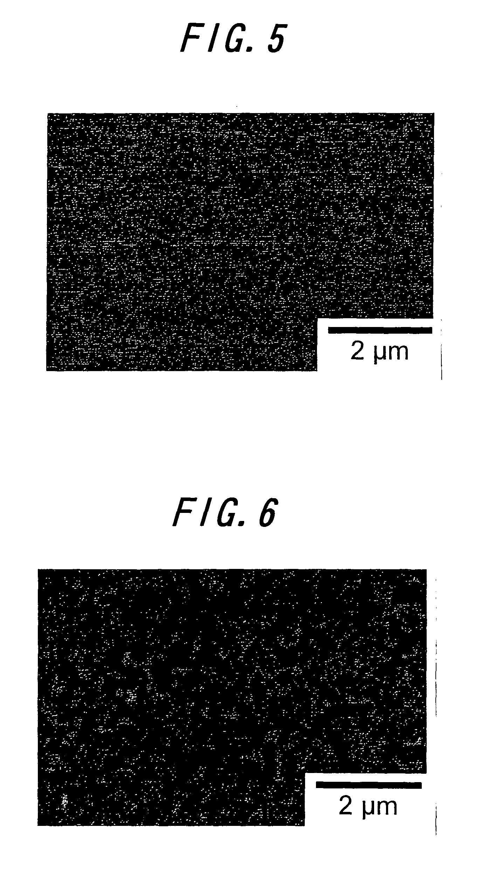

Fig. 5 is a surface SEM photograph of the nickel silicide film obtained in Example 2, and Fig. 6 is a surface SEM photograph of the nickel silicide film obtained in Comparative Example 2. In both cases, the nickel silicide films are formed through the additional thermal treatment of 750°C. As is apparent from Figs. 5 and 6, the surface of the nickel silicide film in Example 2 according to the present invention is extremely uniform, but the surface of the nickel silicide film in Comparative Example 2 is not uniform. Also, on the analysis utilizing characteristic X-ray, it is turned out that the black areas in Fig. 6 mean exposed portions of the silicon substrate.

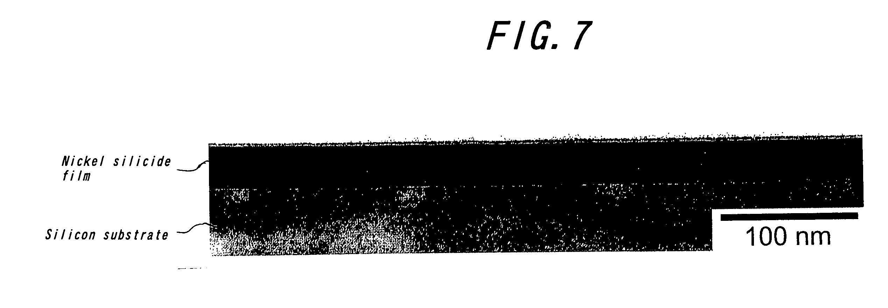

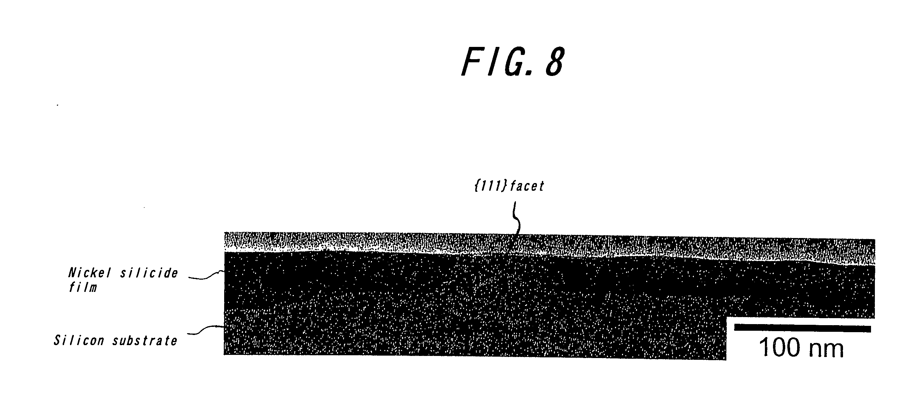

Fig. 7 is a cross sectional TEM photograph of the nickel silicide film obtained in Example 2, and Fig. 8 is a cross sectional TEM photograph of the nickel silicide film obtained in Comparative Example 2. In both cases, the nickel silicide films are formed through the additional thermal treatment of 850°C. As is apparent from Figs. 7 and 8, the nickel silicide film in Example 2 according to the present invention can have a flat boundary surface in the order of atomic level. In the nickel silicide film in Comparative Example 2, however, {111} facets are locally created at the boundary surface, so that no flat boundary surface can be formed and the concave-convex boundary can be formed.

Although the present invention was described in detail with reference to the above examples, this invention is not limited to the above disclosure and every kind of variation and modification may be made without departing from the scope of the present invention.

## Claims

1. A method for fabricating a silicide film, comprising the steps of:
preparing a silicon substrate,
forming a titanium intermediate layer on said silicon substrate,
forming, on said titanium intermediate layer, a compound element-containing layer containing compound elements to compose an intended silicide film, to form a multilayered intermediate structure, and
thermally treating said multilayered intermediate structure to form said intended silicide film made of silicon elements of said silicon substrate and said compound elements of said compound element-containing layer.

2. The fabricating method as defined in claim 1, wherein a thickness of said titanium intermediate layer is set to 50nm or below.

3. The fabricating method as defined in claim 1 or 2, wherein said silicide film is an epitaxial film.

4. The fabricating method as defined in any one of claims 1-3, wherein said compound element-containing layer is a nickel layer, and said silicide film is a nickel silicide film.

5. The fabricating method as defined in claim 4, wherein said nickel silicide film is a nickel disilicide (NiSi₂) film.

6. The fabricating method as defined in claim 4 or 5, wherein said thermal treatment is carried out at 350°C or below.

7. The fabricating method as defined in any one of claims 1-3, further comprising the step of additionally thermally treating said silicide film.

8. The fabricating method as defined in any one of claims 4-6, further comprising the step of additionally thermally treating said nickel silicide film.

9. The fabricating method as defined in claim 8, wherein said additional thermal treatment is carried out at 400°C or over.

10. The fabricating method as defined in any one of claims 1-9, wherein a boundary surface between said silicon substrate and said silicide film is flat in the order of atomic level.

11. A multilayered intermediate structure comprising:
a given silicon substrate,
a titanium intermediate layer formed on said silicon substrate, and
a compound element-containing layer containing compound elements to compose an intended silicide film with silicon elements of said silicon substrate.

12. The multilayered intermediate structure as defined in claim 11, wherein a thickness of said titanium intermediate layer is set to 50nm or below.

13. The multilayered intermediate structure as defined in claim 11 or 12, wherein said compound element-containing layer is a nickel layer.

14. A multilayered structure comprising:
a silicon substrate, and
a silicide film formed on said silicon substrate,
wherein a boundary surface between said silicon substrate and said silicide film is flat in the order of atomic level.

15. The multilayered structure as defined in claim 14, wherein said silicide film is an epitaxial film.

16. The multilayered structure as defined in claim 14 or 15, wherein said silicide film is a nickel silicide film.

17. The multilayered structure as defined in claim 16, wherein said nickel silicide film is a nickel disilicide (NiSi₂) film.
